# EUROPÄISCHE PATENTSCHRIFT

(11) **EP 0 336 232 B1**
(45) Veröffentlichungstag und Bekanntmachung des Hinweises auf die Patenterteilung: **16.06.1993**
(21) Anmeldenummer: 89105234.2
(22) Anmeldetag: 23.03.1989
(51) Int. Cl.: H05K 3/34

(54) **Verfahren und Vorrichtung zum Tauchbeloten von Leiterplatten**
Method for dip-soldering printed-circuit boards
Procédé et dispositif pour le soudage par trempage de plaques conductrices

(30) Priorität: 29.03.1988 DE 3810653
(43) Veröffentlichungstag der Anmeldung: 11.10.1989
(73) Patentinhaber: Friedrich, Dieter, Dr.-Ing., D-90427 Nürnberg (DE); Friedrich, Gitta, D-90427 Nürnberg (DE)
(72) Erfinder: Friedrich, Dieter, Dr.-Ing., D-90427 Nürnberg (DE); Friedrich, Gitta, D-90427 Nürnberg (DE)
(74) Vertreter: Hafner, Dieter, Dr.rer.nat., Dipl.-Phys.

(56) Entgegenhaltungen:
- WO-A-84/01258
- DE-A- 2 755 926
- DE-A- 3 445 625
- DE-A- 3 724 005
- US-A- 2 964 007
- US-A- 3 053 215
- US-A- 4 694 572

## Beschreibung

Die Erfindung betrifft ein Verfahren zum Tauchbeloten von Leiterplatten.

Ferner betrifft die Erfindung eine Vorrichtung zum Tauchbeloten von Leiterplatten, mit den Merkmalen des Oberbegriffs des Anspruchs 18.

### Der Stand der Technik:

Es sind unterschiedliche Methoden bekannt geworden, um Leiterplatten bereichsweise so zu beloten, daß sie anschließend an die Bestückung mit SMD-Bauelementen mit diesen durch Reflowlötverfahren elektrisch und mechanisch verbunden werden können. Einzelheiten über das Reflowlötverfahren gehen beispielsweise aus der deutschen Patentanmeldung P 37 24 005 hervor. Insbesondere wird im Stand der Technik ein Verfahren angewandt, bei dem der Lotauftrag als Lotdepot über Sieb- oder Maskendruck von Lotpasten auf die ausgewählten Leiterplattenbereiche aufgebraucht wird.

Dieses bekannte Verfahren ist in vielerlei Hinsicht nicht als optimal zu bezeichnen. So sind beispielsweise die Investitionskosten der notwendigen Siebdruckmaschinen, Siebe und Masken sehr erheblich, die zu verwendenden Siebe verschleißen regelmäßig, der gesamte Siebdruckvorgang muß laufend überwacht werden, da es nicht auszuschließen ist, daß sich die verwendeten Siebe bereichsweise zusetzen, oftmals kommt es zu sog. mageren Lötstellen, die eine geringe mechanische und thermische Belastbarkeit der darauf aufgebauten Lötverbindungen zur Folge haben. Ferner sind Lotpasten teuer, das Auflösungsverfahren der Siebdruckverfahren ist begrenzt, die optoelektronische Lageerkennung von Bestückungssystemen durch nicht konturentreuen Lotpastenauftrag ist mit großen Schwierigkeiten verbunden, so daß es zu Fertigungstoleranzen kommt. Verkettete Fertigungslinien mit Siebdruckautomaten werden in ihrer Flexibilität stark beeinträchtigt, da Siebdruckmaschinen erhebliche Rüstzeiten und Einstellarbeiten mit sich bringen. Darüberhinaus hat sich die Aufheizgeschwindigkeit der Wärmeeinbringung beim Reflowlöten durch Lotpasten als begrenzt erwiesen, da beim Erwärmen dampfförmige Bestandteile und Lösungsmittel aus der Lotpaste ausdampfen müssen, was einen gewissen Zeitraum beansprucht.

Ein weiteres, häufig angewandtes Verfahren nach dem Stand der Technik ist die sog. Tauchbelotung von Leiterplatten, bei dem eine vorbereitete Leiterplatte in ein Lotbad ein- und ausgetaucht wird. Nach dem Austauchen und einer Abkühlphase sind die nicht mit einem Lötstopmittel versehenen metallisierten Bereiche der Leiterplatte mit einem Lotauftrag versehen, der allerdings eine mehr oder weniger kalottenförmige Querschnittsform hat. Die Höhe des Lotauftrages hängt zudem von den Dimensionen (in Leiterplattenebene) der zu belotenden Bereiche ab, so daß bei zu belotenden Bereichen unterschiedlicher Dimensionen zwangsläufig unterschiedlich hohe Lotaufträge entstehen (DE 86 02 631 U1).

Um dies auszugleichen, ist es auch durch diese Druckschrift bereits bekannt geworden, durch sog. "hot air levelling"-Verfahren, d. h. Anwendung eines gerichteten Heißluftstromes allzu hohen Lotauftrag wieder abzutragen. Ein derartiges Nivellierungsverfahren ist jedoch sehr aufwendig und verteuert daher die Fertigung.

### Die Aufgabenstellung:

Der Erfindung liegt die Aufgabe zugrunde, ein verbessertes Verfahren zum Tauchbeloten von Leiterplatten anzugeben, das - ähnlich wie ein Siebdruckverfahren - zu einem Lotauftrag im wesentlichen rechteckigen Querschnittes führt, dessen Auftragshöhe von den Dimensionierungen der Lotauftragsflächen unabhängig ist, das - verglichen mit den Drucken von Lotpasten nach dem Stand der Technik - billig ist und die Bereitstellung von beloteten Leiterplatten ermöglicht, die vom Anwender unmittelbar oder ggf. nach zusätzlichem Flußmittelauftrag auch in komplizierten SMD-Bestückungsverfahren eingesetzt werden können.

Ferner liegt der Erfindung die Aufgabe zugrunde, eine verbesserte Vorrichtung zum Tauchbeloten von Leiterplatten anzugeben, insbesondere eine Vorrichtung zur Durchführung des Verfahrens nach der Erfindung.

### Die Lösung:

Diese Aufgabe wird bei einem Verfahren zum Tauchbeloten von Leiterplatten durch die Gesamtheit der Verfahrensschritte gemäß dem kennzeichnenden Teil des Patentanspruches 1 gelöst.

Jeweils vorteilhafte weitere Ausgestaltungen des Verfahrens nach der Erfindung ergeben sich aus den Ansprüchen 2 - 17. Die nach dem erfindungsgemäßen Verfahren tauchbeloteten Leiterplatten weisen insbesondere die folgenden Vorteile auf:

Die Qualität und vor allem die Homogenität der erzielbaren Lotverbindungen sind - verglichen mit dem Stand der Technik - außergewöhnlich gut, was darauf zurückzuführen ist, daß bei dem erfindungsgemäßen Verfahren ein Lotpastenauftrag im herkömmlichen Sinne und die damit verbundenen Nachteile, wie insbesondere Lunkerbildung, Oxidation der Lotpaste, kleine Körnung und dergleichen mehr vermieden werden.

Aufgrund der erfindungsgemäß durchgeführten Tauchbelotung werden in der Tat auf der Platine homogen ausgeformte Lotdepots mit einem nahezu rechteckigen Querschnitt geschaffen, wobei in diesen Lotdepots außer Lot keine fremden Bestandteile enthalten sind, wodurch die Qualität der Lötverbindung letztendlich stark verbessert wird.

Da die Lotaufträge quasi ein homogenes Kontinuum sind und nicht ein Konglomerat unterschiedlicher Bestandteile wie beim konventionellen Lotpastenauftrag, werden beim erfindungsgemäßen Verfahren auch Lotperlen- oder Brückenbildungen, sowie das Auftreten von Kurzschlüssen weitestgehend vermieden.

Weitere Vorteile ergeben sich hinsichtlich Layout, Lagerung, engeren Rastermaßen für die Verarbeitung von IC's oder anderen Anschlüssen, neuen Gehäuseformen und dgl. mehr.

Das erfindungsgemäße Verfahren sieht insbesondere zunächst das Herstellen einer Leiterplatte mit metallisierten Bereichen vor, die mit einem Lotauftrag zu versehen sind. Z.B. ist zu unterscheiden zwischen solchen Bereichen, die ggf. mit einer flachen Lotschicht zu versehen sind, und Bereichen, die mit einer Schicht relativ hoher Lotmasse zu versehen sind. Letztere werden für die bereits erwähnten SMD-Verfahren eingesetzt und verfahrensgemäß mit einer eine Belotung verhindernden Begrenzungsschicht definierter Schichtdicke umgeben, welche im wesentlichen der Höhe des zu erzeugenden Lotauftrages entspricht.

Die so vorbereitete Leiterplatte wird in ein Lotbad mit einer geeigneten Lotlegierung eingetaucht, so daß sich die über den Bereichen liegenden, durch die Begrenzungsschicht seitlich begrenzten Kavitäten mit dem flüssigen Lot füllen. Sodann wird im Lotbad die Leiterplatte mit Hilfe entsprechender Elemente oder Vorrichtungen in der Weise abgedeckt, daß beim Austauchen der Leiterplatte das noch flüssige Zinn vollständig in den Hohlräumen verbleibt. Dazu wird ein Abschlußelement verwendet, das beispielsweise eine Platte sein kann, die die Begrenzungsschicht der Leiterplatte unter definiertem Anpreßdruck ggf. mit einer elastischen Oberfläche beaufschlagt. In diesem beaufschlagten, d. h. abgeschlossenen Zustand wird die Leiterplatte aus dem Lotbad ausgetaucht, es folgt ein Abkühlungsvorgang ggf. sogar ein intensiver Abschreckvorgang, beispielsweise durch ein Flüssigkeitsbad, bei welchem die Lotlegierung ihre Erstarrungstemperatur unterschreitet. Sodann wird das Abschlußelement abgehoben, hierbei ist bedeutungsvoll, daß die Oberfläche des Abschlußelementes so ausgebildet sein muß, daß sie vom Lot nicht benetzt wird. Ansonsten bestünde die Gefahr, daß beim Abheben des Abschlußelementes der Lotauftrag von seiner Oberfläche abgerissen wird. Um ein ungestörtes Aufbringen der Bauteile zu ermöglichen, deren Anschlüsse nicht oder nicht wesentlich über die untere Fläche des Bauteilkörpers hinausstehen, kann es zweckdienlich sein, die Begrenzungsschicht abzulösen oder abzuwaschen, die entweder eine fotosensitive Lötstopmaske oder eine bereichsweise aufgebrachte Folienschicht ist. Dieser Schritt kann allerdings entfallen, ohne die Erfindung zu verlassen, falls mit den SMD-Lötflächen Bauteile elektrisch verbunden werden, deren Anschlußbeine nach unten über den Bauteilkörper hinausstehen. Die Schichtdicke der Begrenzungsschicht kann zur vorteilhaften Durchführung des Verfahrens vorzugsweise zwischen 10 µm und 350 µm liegen.

Wird eine fotosensitive Lötstopmaske als Begrenzungsschicht verwendet, so kann auf relativ einfache Weise eine Bearbeitung, d. h. ein "Ausschneiden" der zu belotenden Bereiche aus der Begrenzungsschicht dadurch erfolgen, daß die Begrenzungsschicht mit einer die SMD-Lötflächen definierenden Fotovorlage belichtet wird. Nach der Belichtung wird die Leiterplatte in ein Bad gebracht, das die belichteten Bereiche entfernt, z.B. auswäscht.

Es kann vorteilhaft sein, vor dem Eintauchen der Leiterplatte auf die ggf. noch nicht vorverzinnten SMD-Lötflächen einen Flußmittelauftrag aufzubringen, um eine sichere Benetzung durch das schmelzflüssige Lot zu erreichen. Ferner kann es vorteilhaft sein, alle zu belotenden Bereiche der Leiterplatte, d. h. Lötaugen, Durchkontaktierungen, SMD-Lötflächen, Pads usw. mit einer Primärbelotung zu versehen. Dies hat allerdings zu geschehen, bevor die Begrenzungsschicht aufgetragen wird. Diese überdeckt dann nämlich auch die Bereiche, die nicht mit den verfahrensgemäßen Lotaufträgen zu versehen sind. Mit anderen Worten werden ausschließlich die SMD-Lötpads von der Begrenzungsschicht nicht überdeckt.

Durch die Begrenzungsschicht werden über den verfahrensgemäß zu belotenden Bereichen - abhängig von deren Dimensionen - relativ enge Kavitäten erzeugt, so daß die Lötstopwirkung der Begrenzungsschichtseitenkanten dazu führen kann, daß in enge Kavitäten das Lotmaterial nur sehr zögernd oder gar nicht eindringt. Um diesem negativen Effekt der Kapillardepression entgegenzuwirken, ist es vorteilhaft, wenn das Lotmaterial die Leiterplattenfläche kurz vor dem Eintauchen oder in der Eintauchzone des Lotbades selbst unter zusätzlich erzeugter Turbulenz anströmt. Turbulenz kann auf unterschiedlichste Weise erzeugt werden, beispielsweise durch Turbulenzdüsen, die im Bereich der Leiterplattenoberfläche einen zumindest teilweise gegen die Oberfläche gerichteten Lotmittelstrom erzeugen, es ist aber auch möglich, Turbulenz durch Bewegen der Leiterplatte im Lotbad selbst zu erzeugen, beispielsweise wäre denkbar, der Leiterplatte im Bad eine Vibrationsbewegung mit relativ hoher Frequenz zu vermitteln, die dafür sorgt, daß auch kleinste Bereiche benetzt werden. Es ist prinzipiell auch möglich, den Lotbehälter in kurzzeitige Schwingungen zu versetzen, um die gewünschte Turbulenz auszulösen, falls die Masse des Lotbehälters dies zuläßt.

Durch die weiterbildenden Verfahrensmaßnahmen nach Anspruch 13 wird die Leiterplatte in bevorzugter Weise zwischen zwei sich bewegenden, umlaufenden Elementen, von denen mindestens eines eine Abschlußoberfläche aufweist und als Abschlußelement dient, aus dem Lotbad ausgetaucht. Die Umlaufbewegung dieser Elemente kann z.B. kontinuierlich erfolgen oder aber auch diskontinuierlich, etwa zwischen verschiedenen Umlaufgeschwindigkeiten umschaltbar sein.

Bei einem derartigen Austauchvorgang ist es gemäß Anspruch 14 außerordentlich günstig, wenn die Leiterplatte zwischen den beiden umlaufenden Elementen (z. B. Förderbänder) durch aufeinanderfolgende Zonen unterschiedlicher Temperatur geführt wird, wobei diese Zonen eine Leiterplattenförderstrecke definieren, wodurch eine Abschreckung der Lotlegierung in den Kavitäten erfolgt, die über den zu belotenden Bereichen liegen.

Nach Anspruch 15 sind vorzugsweise eine Heizung der im Lotbad eintauchenden untersten Zone und eine Kühlung einer oder mehrerer Zonen vorgesehen, die vorzugsweise am Ende der Leiterplattenförderstrecke angeordnet ist oder sind.

Eine verhältnismäßig sehr rasche Abkühlung der Leiterplatte nach deren Austauchen aus dem Lotbad und damit die Erzielung eines Abschreckungseffekts ist aus metallurgischen Gründen außerordentlich erwünscht, wie dies weiter unten im Rahmen der Beschreibung der Ausführungsbeispiele noch näher erläutert wird.

Weitere Verfahrensausgestaltungen ergeben sich aus den Ansprüchen 16 und 17.

Wie bereits weiter oben erwähnt, betrifft die Erfindung auch eine Vorrichtung zum Tauchbeloten von Leiterplatten, mit den Merkmalen des Oberbegriffs des Anspruchs 18. Diese Vorrichtung weist im wesentlichen eine Haltevorrichtung auf, die vorzugsweise aus einem vom Lot nicht benetzbaren Material besteht und an der eine zur Tauchbelotung vorbereitete Leiterplatte anbringbar ist, ferner ist eine Transportvorrichtung vorgesehen, mit der die (bestückte) Haltevorrichtung mit einer vertikalen und/oder horizontalen Komponente bewegbar ist, und weiterhin ist ein Lotbehälter vorgesehen, der mit flüssigem Lot gefüllt ist und in den die mit einer Leiterplatte bestückte Haltevorrichtung eingeführt werden kann.

Um sicherzustellen, daß das flüssige Lot beim Austauchvorgang bis zur Erstarrung im durch die Begrenzungsschicht definierten Bereich festgehalten wird, ist an der Vorrichtung nach Anspruch 18 erfindungsgemäß mindestens eine Abdeckvorrichtung vorgesehen, die im Lotbehälter gegen die mit Lot benetzte Oberfläche der Leiterplatte preßbar und in Preßstellung zusammen mit der Leiterplatte aus dem Lotbehälter austauchbar ist.

Es ist erfindungsnotwendig, daß die Abdeckvorrichtung keine wesentliche Relativbewegung zur Leiterplattenoberfläche ausführt, um die notwendige Abdichtwirkung sicherzustellen. Dazu kann es vorteilhaft sein, daß die Abdeckvorrichtung über eine scharnierartige Befestigung mit der Haltevorrichtung verbunden ist. Weiterhin ist es zweckdienlich, wenn die Bewegung der Abdeckvorrichtung von außerhalb des Lotbehälters steuerbare Antriebsmittel aufweist, es ist allerdings auch möglich, die AnpreßSchließbewegung der Abdeckvorrichtung durch ein mechanisches Element zu initiieren, das innerhalb des Lotbehälters liegt, beispielsweise einen Vorsprung, der die Sperrklinke eines Federrastgesperres entklinkt, so daß eine Feder die Schließbewegung verursacht.

Wie vorstehend bereits erläutert, kann es auch zweckdienlich sein, zur Erzeugung von Turbulenzen eine Relativbewegung zwischen Leiterplatte und Bad vorzunehmen, wozu z. B. die Vorrichtung einen motorischen Antrieb an der Haltevorrichtung aufweisen kann, der für eine Hin-und Herbewegung der Leiterplatte im Lotbad sorgt. Der motorische Antrieb kann entweder die gesamte Haltevorrichtung hin- und herbewegen oder so an der Haltevorrichtung angeordnet sein, daß ausschließlich die Leiterplatte bewegt wird.

In bevorzugter Weise kann dieser Antrieb durch einen Vibrator gebildet sein.

Im Rahmen einer vorteilhaften Weiterbildung der erfindungsgemäßen Vorrichtung kann gemäß Anspruch 25 die Abdeckvorrichtung in bevorzugter Weise als Förderband ausgebildet sein, an dessen Oberfläche die Leiterplatte unter definiertem Anpreßdruck anliegt und aus dem Lotbad geführt wird.

Insbesondere kann diese Abdeckvorrichtung aus zwei gegensinnig umlaufenden, zwischen sich einen Aufnahmespalt mit z.B. variabler Spaltweite für die Leiterplatte bildenden Förderbändern bestehen (Anspruch 26).

Weitere vorteilhafte Ausgestaltungen der erfindungsgemäßen Vorrichtung, bei welcher die Abdeckvorrichtung durch zwei Förderbänder gebildet ist, ergeben sich aus den Ansprüchen 27 - 29.

Die Erfindung ist anhand vorteilhafter Ausführungsbeispiele in den Zeichnungsfiguren näher erläutert, diese zeigen:
- Fig. 1: einen Schnitt durch eine Leiterplatte, die nach einem herkömmlichen Tauchbelotungsverfahren nach dem Stand der Technik belotet ist;
- Fig. 2: einen Schnitt durch eine erfindungsgemäß vorbereitete, in einem Lotbad befindliche Leiterplatte;
- Fig. 3: einen Schnitt gemäß Fig. 2 nach Aufsetzen der Abdeckvorrichtung;
- Fig. 4: einen Schnitt durch eine verfahrensgemäß hergestellte Leiterplatte nach dem Abheben der Abdeckvorrichtung;
- Fig. 5: einen Schnitt gemäß Fig. 4 nach dem Ablösen der Begrenzungsschicht;
- Fig. 6: eine schematische Darstellung einer mit einer Abdeckvorrichtung versehenen Haltevorrichtung beim Eintauchen in ein Lotbad;
- Fig. 7: eine schematische Darstellung einer mit einer Abdeckvorrichtung versehenen Haltevorrichtung in geschlossener Stellung beim Austauchen aus dem Lotbad;
- Fig. 8: ein Verfahrensdiagramm zur Erläuterung der wesentlichen Verfahrensschritte und apparativen Stationen; und
- Fig. 9 und 10: in schematischer Darstellung ein weiteres Ausführungsbeispiel einer Vorrichtung zum Tauchbeloten von Leiterplatten, wobei in diesem Falle die Abdeckvorrichtung aus zwei teilweise in das Lotbad eintauchenden Förderbändern besteht. (Fig. 9 ist i.w. eine Schnittansicht in Richtung X - X von Fig. 10).

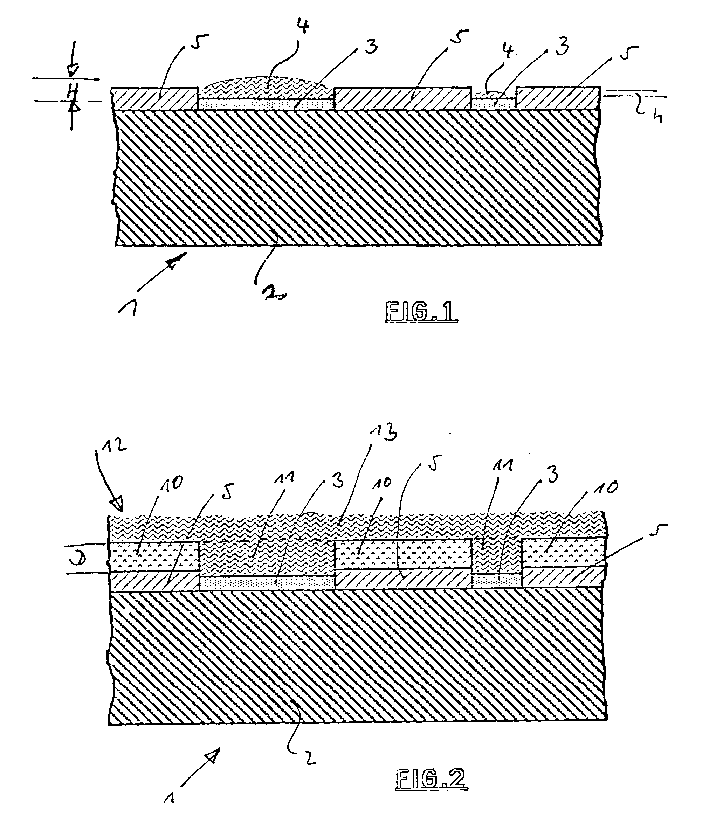

Die in den Fig. 1 - 5 im Schnitt dargestellte Leiterplatte 1 besteht i. w. aus einem Trägerkörper 2 aus einem plattenförmigen Isolierstoff, auf welchem leitfähige Bereiche 3 angeordnet sind, die mit einem Lotauftrag 4 zu versehen sind. Beim Stand der Technik war es bereits üblich, diese Bereiche 3 mit einer eine Belotung verhindernden Schicht 5 zu umgeben, die beispielsweise durch einen Lötstoplackauftrag gebildet werden kann.

Wie deutlich zu sehen ist, haben die durch ein Tauchbelotungsverfahren nach dem Stand der Technik hergestellten Leiterplatten 1 einen Lotauftrag 4, bei dem sich aufgrund der hohen Oberflächenspannung des Lotes eine kugelige Oberfläche ausbildet. Darüber hinaus ist deutlich zu sehen, daß die Höhe H des linksseitig dargestellten Lotauftrages von der Höhe h des rechts dargestellten Lotauftrages abweicht.

Es muß angemerkt werden, daß der Stand der Technik sich in zwei Varianten unterteilt, nämlich
a) die entsprechend Fig. 1 (Tauchbelotung ohne anschließendes Abblasen bzw. Nivellieren), und
b) Tauchbeloten mit anschließendem Nivellieren (z. B. Hot-air- oder Öl-Verfahren),
wobei nach Variante b) der Lotauftrag vergleichmäßigt, aber zugleich auch in der Dicke erheblich reduziert wird, zum Beispiel auf 10 µm. Variante b) ist das heute in der Leiterplattentechnik hauptsächlich angewandte Verfahren zur Erzeugung gut lötbarer SnPb-Überzüge auf Lp-Lötstellen. Variante a) wird allerdings als der zu dem erfindungsgemäßen Verfahren nächstliegende Stand der Technik angesehen.

Fig. 2 zeigt nunmehr einen Abschnitt einer Leiterplatte 1 gemäß Fig. 1, die auf den Schichtabschnitten 5 eine eine Belotung verhindernde Begrenzungsschicht 10 mit definierter Schichtdicke D trägt, die i w. der Höhe des zu erzeugenden Lotauftrages entspricht. Unter Umständen kann es möglich sein, daß geringfügige Differenzen dadurch entstehen, daß die Bereiche 3 aus leitfähigem Material eine etwas geringere Schichtdicke als die sie umgebende erste Schicht 5 haben, auf welchletztere die Begrenzungsschicht aufgetragen ist.

Über den Bereichen 3 werden durch die Begrenzungsschicht 10 Hohlräume 11 gebildet, die in einem Tauchbad 12 mit flüssigem Lot 13 gefüllt werden. Die Hohlräume 11 werden an ihrem Boden von den Bereichen 3, an ihren Seitenwänden von der Begrenzungsschicht 10 und/oder ggf. noch von der ersten Schicht 5 begrenzt.

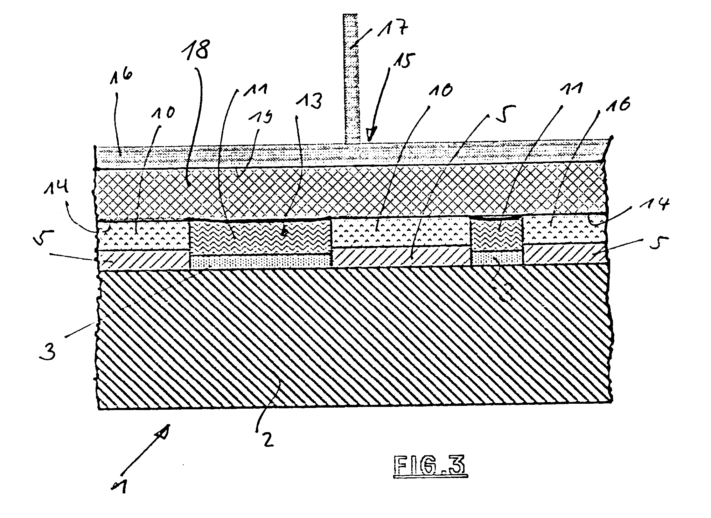

Bei dem in Fig. 3 dargestellten Abschnitt einer Leiterplatte 1 herrschen die in Fig. 2 dargestellten Verhältnisse vor, lediglich ist gegen die freie Oberfläche 14 der Begrenzungsschicht 10 ein Abschlußelement 15 gedrückt, das aus einer Platte 16, einem Führungselement 17 und einer elastischen Dichtungsschicht 18 besteht, die zwischen der der Leiterplatte 1 zugewandten Flachseite 19 der Platte 16 und der Leiterplatte 1 angeordnet ist. Die die freie Oberfläche 14 beaufschlagende Fläche der Dichtungsschicht 18 wölbt sich durch den aufgebrachten Anpreß- bzw. Abdichtungsdruck etwas in die Hohlräume 11 hinein, so daß die von der Dichtungsschicht 18 beaufschlagte Lotfläche etwas konkav ausgeformt wird und - nachdem die gesamte Anordnung aus Leiterplatte 1 und darauf dichtend aufgesetztem Abschlußelement 15 aus dem Lotbad herausgenommen wurde - auch mit einer etwas konkaven freien Oberfläche erstarrt.

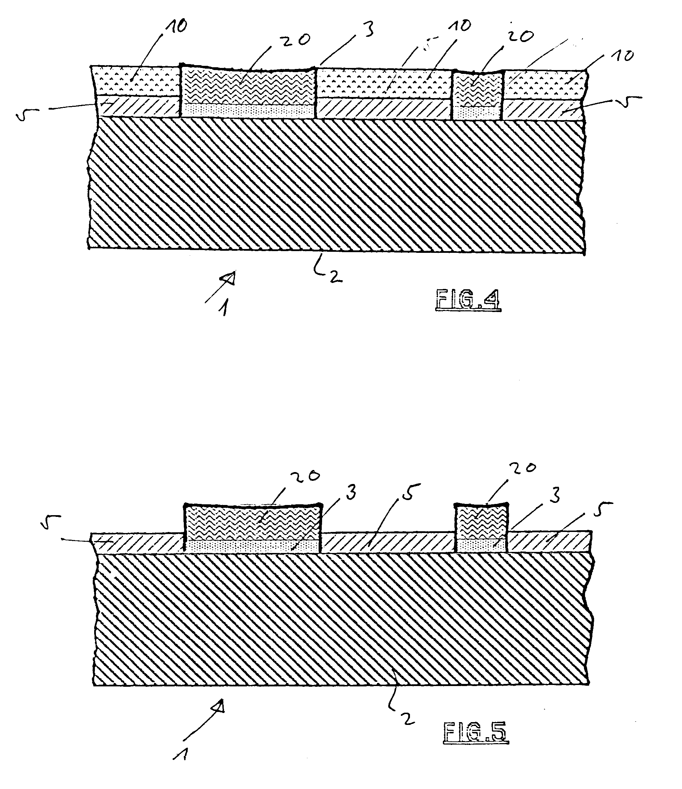

Fig. 4 zeigt einen Leiterplattenabschnitt 1 entsprechend Fig. 3, von dem das Abschlußelement 15 entfernt wurde, bei dem in Fig. 5 dargestellten Abschnitt sind die als Ergebnis des Verfahrens gebildeten Lotschichten 20 gezeigt.

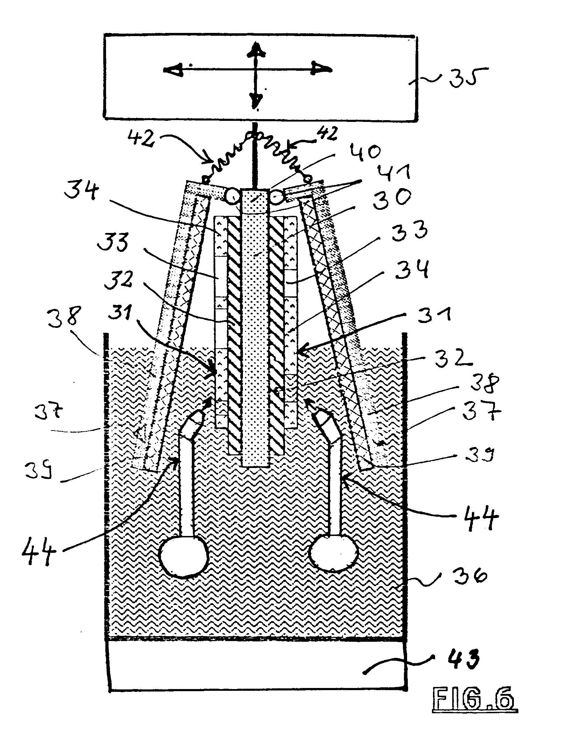

Bei dem in Fig. 6 dargestellten schematisierten Ausführungsbeispiel ist eine Haltevorrichtung 30 vorgesehen, an der beidseitig zwei Leiterplatten 31 so angeordnet sind, daß die Unterseiten der Trägerkörper 32 an der Haltevorrichtung 30 anliegen, die zur Belotung vorgesehenen Bereiche 33, die von Begrenzungsschichten 34 umgeben sind, hingegen freiliegen. Es ist auch eine Haltevorrichtung denkbar, an der mehr als zwei Leiterplatten anbringbar sind, genauso ist es denkbar, eine Haltevorrichtung so auszubilden, daß eine beidseitig bestückte Leiterplatte (dies ist bei SMD-bearbeiteten Leiterplatten grundsätzlich möglich) an ihr befestigt und in das Lotbad eingebracht wird. Die Haltevorrichtung ist an einer nur schematisiert dargestellten Transportvorrichtung 35 angeordnet, durch die die bestückte Haltevorrichtung über einen Lotbehälter 36 gefahren werden kann, in diesen ein- und ausgetaucht werden kann und ggf. zur nächsten Bearbeitungsstation weitergefahren werden kann.

An der Haltevorrichtung 30 sind Abdeckvorrichtungen 37 angeordnet, die aus je einer Platte 38 sowie einer elastischen oder nicht elastischen Dichtungsschicht 39 bestehen. Am oberen Ende 40 sind die Platten 38 der Abdeckvorrichtungen 37 mittels Scharnieren 41 an der Haltevorrichtung 30 befestigt.

In der in Fig. 6 dargestellten geöffneten Stellung wird die mit den Leiterplatten 31 bestückte Haltevorrichtung 30 in den mit flüssigem Lot gefüllten Lotbehälter 36 eingetaucht. Im Bereich der Eintauchzone sind z.B. bewegliche Lotmittel-Turbulenzdüsen 44 angeordnet, die einen zumindest teilweise gegen die Oberflächen der Leiterplatten 31 gerichteten Lotmittelstrom erzeugen, um eine Benetzung auch kleinster Bereiche 33 zu gewährleisten.

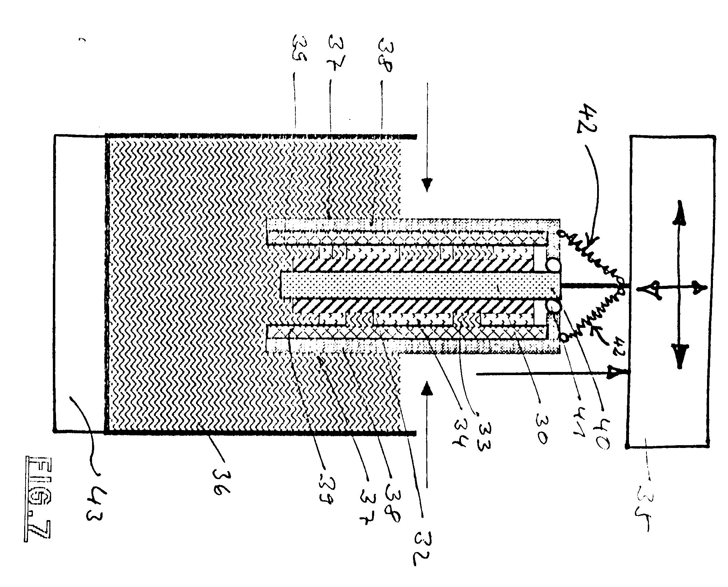

Sobald im Lotbad die Bereiche 33, die zur Belotung vorgesehen sind, völlig benetzt sind, werden die Abdeckvorrichtungen 37 geschlossen und die gesamte Vorrichtung in der in Fig. 7 dargestellten Schließstellung aus dem Lotbehälter 36 wieder ausgetaucht. Sobald das in den Hohlräumen 11 eingeschlossene Lot seinen Erstarrungspunkt unterschritten hat, können die Abdeckvorrichtungen 37 geöffnet und die beloteten Leiterplatten 31 entnommen werden. Es ist auch möglich, mittels der Transportvorrichtung 35 die gesamte geöffnete Vorrichtung in ein Bad einzutauchen, in welchem die Begrenzungsschichten 34 abgewaschen werden, so daß als Verfahrensendprodukt eine Leiterplatte entsteht, wie sie beispielsweise in Fig. 5 dargestellt ist.

Bei Laborversuchen hat sich herausgestellt, daß es zweckmäßig sein kann, die in das Lotbad eintauchenden Elemente (Haltevorrichtung, Trägerkörper, Abdeckvorrichtung, Platte, Dichtungsschicht u. dgl.) vor dem Eintauchen in das Lotbad vorzuwärmen (auf eine Temperatur oberhalb des Schmelzpunktes des Lotes bzw. auf die Temperatur des Lotbades selbst), und daß es weiterhin zweckmäßig sein kann, die gesamte Anordnung (einschließlich Leiterplatte) in noch geschlossenem Zustand nach dem Austauchen aus dem Lotbad einer intensiven Kühlung zu unterziehen (zum Beispiel durch das Eintauchen in ein Wasserbad), um so den Erstarrungsverlauf zu beschleunigen und hierdurch ein zu starkes Anwachsen der intermetallischen CuSn-Phasen zu unterbinden. Zur Beheizung der oben bezeichneten Elemente kann es zweckdienlich sein, an der Haltevorrichtung und/oder der Abdeckvorrichtung eine Heizvorrichtung anzuordnen.

Für die Abdeckvorrichtungen 37 können Antriebsmittel zur Durchführung der Anpreß-/Schließbewegung vorgesehen sein, die durch Druckfedern 42 angedeutet sind. Andere, beispielsweise elektromechanische, pneumatische, hydraulische o. dgl. Mittel sind ebenso denkbar. Es liegt ferner im Rahmen der Erfindung, die Abdeckvorrichtungen in einer durch die Druckfedern 42 vorgespannten Öffnungsstellung solange festzuhalten, bis eine Rastvorrichtung beim Eintauchvorgang eine Freigabevorrichtung betätigt, die die Abdeckvorrichtungen unter dem Druck der Federn 42 in die in Fig. 7 dargestellte Schließstellung überführt.

Aus den Fig. 6 und 7 ist noch ersichtlich, daß unmittelbar unterhalb des Lotbehälters 36 ein Vibrator 43 angeordnet ist, durch den die Haltevorrichtung 30 innerhalb des Lotbehälters 36 in eine Hin- und Herbewegung versetzt wird, z.B. in eine Vibrationsbewegung mit relativ hoher Frequenz, wodurch auch kleinste Leiterplattenbereiche benetzt werden (ggf. zusätzich zu oder anstelle von Lotmittelturbulenzdüsen 44).

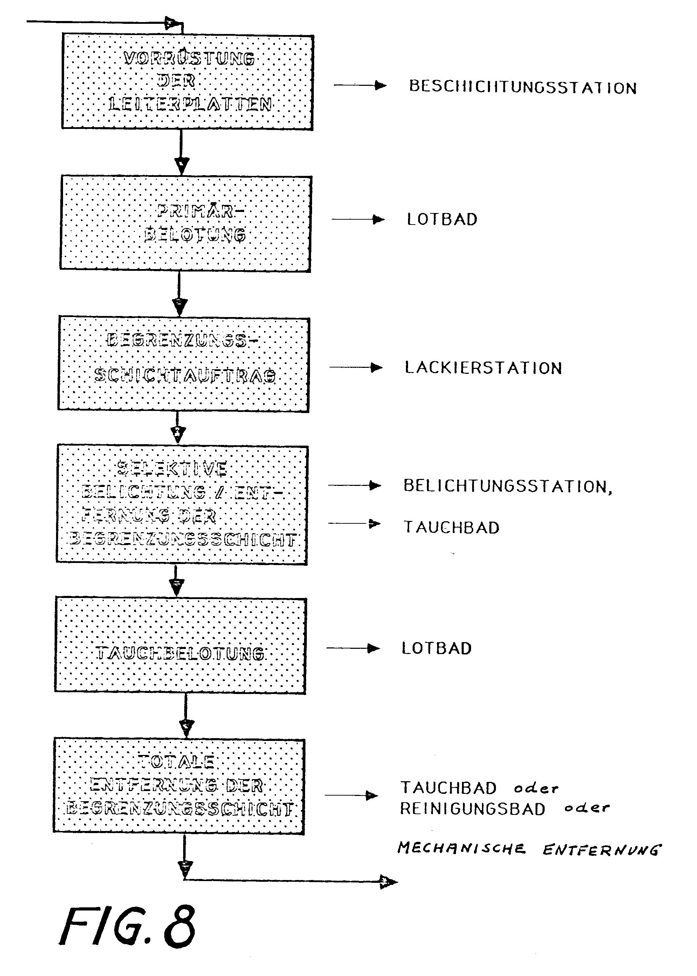

In Fig. 8 ist nochmals in Form eines Ablaufdiagrammes das Wesen des erfindungsgemäßen Verfahrens in den jeweils zugehörigen Bearbeitungsstationen dargestellt.

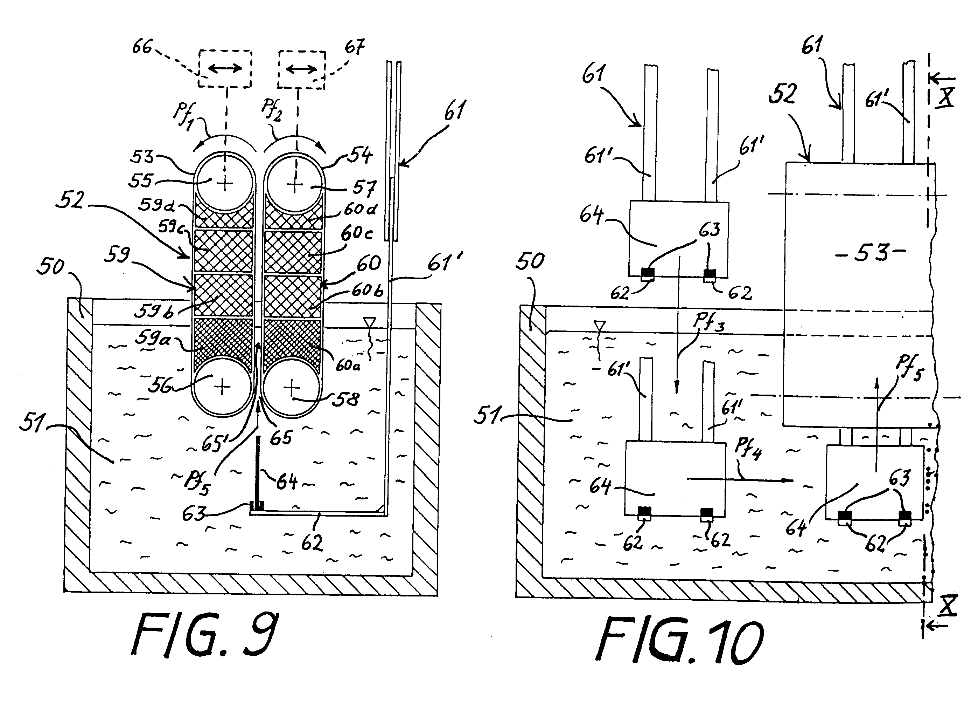

Bei dem in Fig. 9 und 10 schematisch dargestellten Ausführungsbeispiel einer Vorrichtung zum Tauchbeloten von Leiterplatten ist wiederum ein Lotbehälter 50 mit einem darin befindlichen, flüssigen Lotbad 51 vorgesehen. In diesem Falle ist die Abdeckvorrichtung als ein Förderbandsystem 52 ausgebildet, welches ein erstes Förderband 53 und ein zweites Förderband 54 aufweist. Das erste Förderband 53 wird über erste und zweite Rollen 55 und 56 geführt, während das zweite Förderband 54 über dritte und vierte Rollen 57 und 58 geführt wird, wobei zum Antrieb dieser Führungsrollen im einzelnen nicht dargestellte Antriebssysteme vorgesehen sind. Mittels dieser Antriebssysteme werden die beiden parallel zueinander ausgerichteten ersten und zweiten Förderbänder 53 und 54 in eine gegensinnige, jedoch synchrone Umlaufbewegung versetzt, wobei in Fig. 9 die Umlaufbewegung des ersten Förderbandes 53 durch einen Pfeil Pf₁ angedeutet ist und die entgegengesetzt gerichtete Umlaufbewegung des zweiten Förderbandes 54 durch einen Pfeil Pf₂.

Weiterhin sind für das erste Förderband 53 ein erstes Förderbandgehäuse 59 und für das zweite Förderband 54 ein zweites Förderbandgehäuse 60 vorgesehen. Diese ersten und zweiten Förderbandgehäuse 59 und 60 sind hierbei so angeordnet, daß sie praktisch den jeweiligen Innenflächen oder Bandunterseiten der ersten und zweiten Förderbänder 53 und 54 unmittelbar benachbart liegen, und damit praktisch diese Bandunterseiten abstützen.

Die ersten und zweiten Förderbandgehäuse 59 und 60 grenzen ferner mit ihren jeweiligen oberen und unteren stirnseitigen Bereichen an die jeweiligen Förderband-Führungs- und Umlenkrollen an, d. h. also bei dem ersten Förderbandgehäuse 59 an die erste (obere) Rolle 55 und die zweite (untere) Rolle 56 und bei dem zweiten Förderbandgehäuse 60 an die dritte (obere) Rolle 57 und die vierte (untere) Rolle 58.

Das gesamte Förderbandsystem 52 ist im übrigen in Bezug auf den Lotbehälter 50 so angeordnet, daß es teilweise in das Lotbad 51 eintaucht, d. h. im vorliegenden Ausführungsbeispiel i. w. mit einem unteren Bereich des Förderbandsystems, welcher die jeweiligen unteren Umlenk- und Führungsrollen für die beiden Förderbänder aufweist. Das Förderbandsystem 52 kann ggf. auch relativ zum Lotbehälter 50 in Vertikalrichtung auf- und abbewegt werden.

Wie in Fig. 9 und 10 ferner dargestellt, ist noch eine Haltevorrichtung 61 zum Anbringen einer zur Tauchbelotung vorbereiteten Leiterplatte 64 vorgesehen. Diese Haltevorrichtung 61 weist i. w. zwei vertikal ausgerichtete Arme 61′ auf, an deren unteren Enden jeweils i. w. rechtwinklig abgewinkelte Trägerplatten 62 angebracht sind, die ihrerseits Aufnahmeeinrichtungen 63 aufweisen, die zur i. w. senkrechten Halterung der Leiterplatte 64 von unten dienen. Für die Herstellung der Haltevorrichtung 61 wird insbesondere ein vom Lot nicht benetzbares Material verwendet.

Gemäß dem Ausführungsbeispiel nach Fig. 10 befindet sich vor Beginn des Tauchbelotungsvorganges die Haltevorrichtung 61 zusammen mit der Leiterplatte 64 noch oberhalb des Flüssigkeitsspiegels des Lotbades 51, und seitlich versetzt in Bezug auf das Förderbandsystem 52.

Bei der Durchführung des Tauchbelotungsvorganges wird nun diese Haltevorrichtung 61 mit Leiterplatte 64 vertikal nach unten abgesenkt und infolgedessen in Richtung eines Pfeiles Pf₃ in das Lotbad 51 eingetaucht.

Sodann wird mit Hilfe der Haltevorrichtung 61 die Leiterplatte 64 durch das Lotbad 51 hindurchbewegt, bis die Leiterplatte 64 schließlich von unten in Richtung eines Pfeiles Pf₅ in einen Einführungsbereich 65 zwischen den beiden ersten und zweiten Förderbändern 53 und 54 eingeführt werden kann, wie Fig. 9 zeigt. Dieser Einführungsbereich 65 geht sodann in einen Aufnahmespalt 65′ für die Leiterplatte 64 über, wobei dieser Aufnahmespalt zwischen den gegenseitig anliegenden ersten und zweiten Förderbändern 53 und 54 ausgebildet ist.

Die Weite des Aufnahmespaltes 65′ läßt sich vorzugsweise variieren, und zwar beispielsweise dadurch - wie in der Fig. 9 schematisch durch gestrichelte Linien angedeutet ist -, daß das erste Förderbandgehäuse 59 mit einer ersten Verschiebevorrichtung 66 und das zweite Förderbandgehäuse 60 mit einer zweiten Verschiebevorrichtung 67 gekoppelt sind, während gleichzeitig diese beiden ersten und zweiten Förderbandgehäuse 59 und 60 in der Horizontalrichtung beweglich gelagert sind. Mit Hilfe der beiden ersten und zweiten Verschiebevorrichtungen 66 und 67 können daher - wie durch die dortigen Pfeile angedeutet - horizontal gerichtete Verschiebebewegungen der beiden ersten und zweiten Förderbandgehäuse 59 und 60 bewirkt werden, wodurch die Weite des Aufnahmespaltes 65′ zwischen den beiden einander zugewendeten Oberflächen der ersten und zweiten Förderbänder 53 und 54 praktisch beliebig eingestellt werden kann.

Weitere Möglichkeiten bezüglich der Variabilität des Aufnahmespaltes 65′ bestehen darin, daß lediglich eines der beiden ersten und zweiten Förderbandgehäuse 59 und 60 mit Hilfe einer Verschiebevorrichtung beweglich ist, während das andere Förderbandgehäuse fest angeordnet ist, oder aber darin, daß die beiden ersten und zweiten Förderbandgehäuse 59 und 60 zur Erzielung gegenseitiger, horizontal gerichteter Verschiebebewegungen federnd in Bezug auf den Lotbehälter 50 gelagert sind. Die im weiteren Verlauf des Tauchbelotungsvorganges in den Aufnahmespalt 65′ mit Hilfe der Haltevorrichtung 61 eingeführte Leiterplatte 64 wird nach oben, d. h. also aus dem Lotbad 51 heraus transportiert, wobei die Leiterplatte 64 unter definiertem Anpreßdruck an den Oberflächen der ersten und zweiten, umlaufenden Förderbänder 53 und 54 anliegt.

Die Leiterplattenführung und -bewegung durch das Lotbad 51 hindurch erfolgt unter Vermeidung jeglicher Querbewegungen relativ zur Leiterplattenoberfläche. Insbesondere ist auch dafür Sorge getragen, daß die Leiterplatte 64 innerhalb des Lotbades 51 zum Einführungsbereich 65 entlang einer i. w. parallel zur Leiterplattenoberfläche verlaufenden Bewegungsbahn gemäß einem Pfeil Pf₄ (siehe Fig. 10) zugeführt wird, wodurch irgendwelche ungünstigen Beeinflussungen der Leiterplatte im Verlaufe ihrer Bewegung durch das Lotbad 51 hindurch vermieden werden.

Bei den ersten und zweiten Förderbändern 53 und 54 handelt es sich im übrigen vorzugsweise um Metallbänder aus Edelstahl, Titan oder ähnlichen Materialien, die eine hohe Flexibilität und eine geringe Wärmeleitung haben und die insbesondere mit einer elastischen Beschichtung auf ihren Außenseiten versehen sind. Sowohl die Förderband-Basismaterialien als auch die für diese vorgesehenen Beschichtungen müssen aus einem lotabweisenden Material bestehen, um im Verlaufe des Tauchbelotungsvorganges ein gegenseitiges Verlöten zwischen den Oberflächen der Förderbänder 53 und 54 und der Leiterplatte 64 zu vermeiden.

Wie ferner aus Fig. 9 ersichtlich, sind in einem jeden der beiden ersten und zweiten Förderbandgehäuse 59 bzw. 60 unterschiedlich temperierte Gehäusezonen 59a - 59d bzw. 60a - 60d ausgebildet. Die ersten und zweiten Förderbänder 53 und 54 tauchen hierbei gemeinsam mit den jeweils zugeordneten, unteren Gehäusezonen 59a und 60a in das Lotbad 51 ein, wobei in diesem Eintauchbereich typischerweise eine Lotbadtemperatur von ca. 250° C herrscht. Unmittelbar oberhalb des Lotbadspiegels schließen sich sodann nicht mehr geheizte, sondern vorzugsweise gekühlte Gehäusezonen 59b bzw. 60b an, und weiterhin in Vertikalrichtung nach oben gesehen weitere Gehäusezonen 59c bzw. 60c und schließlich Gehäusezonen 59d bzw. 60d.

Vorzugsweise sind für die jeweiligen aus dem Lotbad 51 herausragenden oberen Gehäusezonen 59b bis 59d des ersten Förderbandgehäuses 59 sowie die Gehäusezonen 60b bis 60d des zweiten Förderbandgehäuses 60 integrierte Kühlvorrichtungen vorgesehen, die im oberen Bereich des Förderbandsystems 52 in den jeweiligen Förderbandgehäusen untergebracht sind und für einen unmittelbaren Wärmeaustausch sorgen.

Somit wird die im Aufnahmespalt 65′ zwischen den beiden ersten und zweiten Förderbändern 53 und 54 befindliche Leiterplatte 64 durch aufeinanderfolgende Zonen unterschiedlicher Temperatur geführt, d. h. von einer unteren, noch im Lotbad 51 liegenden Zone nach oben in Richtung zu den gekühlten Zonen, wobei durch diese Zonen - entsprechend den Gehäusezonen 59a - 59d bzw. 60a - 60d - eine vollständige Leiterplattenförderstrecke definiert ist.

Durch eine gezielte Kühlung der Zonen, die dem oberhalb des Lotbadspiegels befindlichen Abschnitt der Leiterplattenförderstrecke entsprechen, wird eine Abschreckung und damit eine Erstarrung der Lotlegierung in den Kavitäten bewirkt, die über den beloteten Bereichen liegen.

Ein derartiger Abschreckungs- und Erstarrungseffekt ist aus folgenden Gründen metallurgisch notwendig und vorteilhaft:
Die resultierende Leiterplattenbelotung weist zwischen der Kupferoberfläche und dem aus SnPb bestehenden Lotauftrag zwei Zwischenphasen oder intermetallische Zonen auf, die aus Cu₃Sn sowie aus Cu₆Sn₅ bestehen und die sich im Verlaufe des Belotungsvorganges aufgrund der hierbei stattfindenden, chemischen Prozesse bilden. Man ist bestrebt, derartige spröde intermetallische Zwischenzonen möglichst dünn zu halten, da bei einem Durchdringen der Zwischenzone an die Oberfläche der SnPb-Schicht die Leiterplatte nur sehr schwer und mit Problemen lötbar wäre.

Das Wachstum derartiger intermetallischer Zwischenzonen hängt nun von Temperatur und Zeit des Tauchbelotungsvorganges ab. Verkürzt man die Verweilzeit im Lotbad, so sind hierdurch relativ dünne Zwischenzonen bzw. -schichten erreichbar. Darüberhinaus würde durch ein zu starkes Anwachsen intermetallischer Zwischenzonen die Duktilität der resultierenden Zinnschicht stark verschlechtert.

Mit Rücksicht auf diesen Sachverhalt wird angestrebt, nicht nur eine relativ kurze Verweilzeit der Leiterplatte im Lotbad vorzusehen, sondern auch die Leiterplatte nach dem Austauchen aus dem Lotbad relativ rasch wieder abzukühlen bzw. abzuschrecken, wobei z. B., wie oben anhand der Fig. 9 erläutert, die Leiterplatte 64 hierzu durch die Zonen unterschiedlicher Temperatur bis hinein in die gekühlten Zonen geführt wird.

Im Anschluß daran wird die fertigbelotete Leiterplatte 64 in einem Ausgabebereich ausgeworfen, welcher in Fig. 9 und 10 der Einfachheit halber nicht näher dargestellt ist.

### Bezugszeichenliste

- 1: Leiterplatte
- 2: Trägerkörper
- 3: Bereiche
- 4: Lotauftrag
- 5: 1. Schicht
- 6:
- 7:
- 8:
- 9:
- 10: Begrenzungsschicht
- 11: Hohlraum
- 12: Lotbad
- 13: Lot
- 14: freie Oberfläche von 10
- 15: Abdeckvorrichtung
- 16: Platte
- 17: Führungselement
- 18: Dichtungsschicht
- 19: Fläche
- 20: Lotschicht
- 21:
- 22:
- 23:
- 24:
- 25:
- 26:
- 27:
- 28:
- 29:
- 30: Haltevorrichtung
- 31: Leiterplatte
- 32: Trägerkörper
- 33: Bereich
- 34: Begrenzungsschicht
- 35: Transportvorrichtung
- 36: Lotbehälter
- 37: Abdeckvorrichtungen
- 38: Platte
- 39: Dichtungsschicht
- 40: Oberes Ende
- 41: Scharniere
- 42: Druckfeder
- 43: Vibrator
- 44: Lotmittel-Turbulenzdüse
- 45:
- 46:
- 47:
- 48:
- 49:
- 50: Lotbehälter
- 51: Lotbad
- 52: Förderbandsystem
- 53: 1. Förderband
- 54: 2. Förderband
- 55: 1. Rolle
- 56: 2. Rolle
- 57: 3. Rolle
- 58: 4. Rolle
- 59: 1. Förderbandgehäuse
- 59a: 1. Gehäusezone (von 59)
- 59b: 2. Gehäusezone (von 59)
- 59c: 3. Gehäusezone (von 59)
- 59d: 4. Gehäusezone (von 59)
- 60: 2. Förderbandgehäuse
- 60a: 1. Gehäusezone (von 60)
- 60b: 2. Gehäusezone (von 60)
- 60c: 3. Gehäusezone (von 60)
- 60d: 4. Gehäusezone (von 60)
- 61: Haltevorrichtung
- 61': vertikaler Arm
- 62: Trägerplatte
- 63: Aufnahmeeinrichtung
- 64: Leiterplatte
- 65: Einführungsbereich (zwischen 53 und 54)
- 65': Aufnahmespalt
- 66: 1. Verschiebevorrichtung
- 67: 2. Verschiebevorrichtung
- Pf₁: 1. Pfeil
- Pf₂: 2. Pfeil
- Pf₃: 3. Pfeil
- Pf₄: 4. Pfeil
- Pf₅: 5. Pfeil

## Patentansprüche

1. Verfahren zum Tauchbeloten von Leiterplatten,
gekennzeichnet durch
folgende Verfahrensschritte:
a) Herstellen einer Leiterplatte mit elektrisch leitfähigen Bereichen, z.B. Lötpads oder SMD-Lötflächen, die mit einem Lotauftrag zu versehen sind;
b) Umgrenzen dieser Bereiche mit einer eine Belotung verhindernden Begrenzungsschicht definierter Schichtdicke, welche im wesentlichen der Höhe des zu erzeugenden Lotauftrages entspricht;
c) Eintauchen der so vorbereiteten Leiterplatte in ein Lotbad mit geeigneter Lotlegierung;
d) Abdecken der über den zu belotenden Bereichen liegenden, im Lotbad mit flüssigem Lot gefüllten Hohlräume mit mindestens einem Abschlußelement unter definiertem Anpreßdruck;
e) Austauchen der abgedeckten Leiterplatte aus dem Lotbad;
f) Unterschreiten der Erstarrungstemperatur der Lotlegierung;
g) Entfernen des Abschlußelementes;
h) ggf. Entfernen der Begrenzungsschicht.

2. Verfahren nach Anspruch 1,
dadurch gekennzeichnet,
daß die Begrenzungsschicht durch eine fotosensitive Lötstopmaske oder durch eine bereichsweise aufbringbare Folienschicht gebildet wird.

3. Verfahren nach Anspruch 1 oder 2,
dadurch gekennzeichnet,
daß die Begrenzungsschicht eine Schichtdicke von ca. 10 µm - 700 µm, vorzugsweise 50 µm - 300 µm aufweist.

4. Verfahren nach einem der vorhergehenden Ansprüche,
dadurch gekennzeichnet,
daß die Begrenzungsschicht entweder mechanisch von der Oberfläche der Leiterplatte ablösbar oder auf chemischem Wege auflösbar ist.

5. Verfahren nach einem der vorhergehenden Ansprüche,
dadurch gekennzeichnet,
daß die zu belotenden Bereiche die SMD-Lötflächen der Platine sind und die Entfernung der belichteten Bereiche einer fotosensitiven Lötstopmaske als Begrenzungsschicht nach einer Belichtung der Begrenzungsschicht mit einer die SMD-Lötflächen definierenden Fotovorlage erfolgt.

6. Verfahren nach einem der vorhergehenden Ansprüche,
dadurch gekennzeichnet,
daß vor dem Eintauchen der Leiterplatte auf die SMD-Lötflächen ein Flußmittelauftrag erfolgt.

7. Verfahren nach einem der vorhergehenden Ansprüche,
gekennzeichnet durch
eine Primärbelotung auf schmelzmetallurgischem Weg aller zu belotenden Bereiche der Leiterplatte, wie z.B. Lötaugen, Durchkontaktierungen, SMD-Lötflächen oder "Lötpads".

8. Verfahren nach einem der vorhergehenden Ansprüche,
dadurch gekennzeichnet,
daß ausschließlich die SMD-Lötflächen oder Lötpads von der Begrenzungsschicht nicht überdeckt werden.

9. Verfahren nach einem der vorhergehenden Ansprüche,
dadurch gekennzeichnet,
daß das Lotmaterial die Leiterplattenfläche insbesondere beim Eintauchen in das schmelzflüssige Lotbad unter zusätzlich erzeugter Turbulenz anströmt.

10. Verfahren nach einem der vorhergehenden Ansprüche,
dadurch gekennzeichnet,
daß das Abschlußelement die über den Bereichen liegenden Hohlräume unter elastischem Druck abdeckt.

11. Verfahren nach einem der vorhergehenden Ansprüche,
dadurch gekennzeichnet,
daß das Abschlußelement eine dichtende und/oder vom Lot nicht benetzbare Abschlußoberfläche aufweist.

12. Verfahren nach einem der vorhergehenden Ansprüche,
dadurch gekennzeichnet,
daß die Abschlußoberfläche des Abschlußelementes deformierbar ausgebildet ist und beim Anpressen auf die Leiterplattenoberfläche zumindest bereichsweise in die über den zu belotenden Bereichen liegenden Hohlräume hineingedrückt wird.

13. Verfahren nach einem der vorhergehenden Ansprüche,
dadurch gekennzeichnet,
daß die Leiterplatte zwischen zwei sich bewegenden, umlaufenden Elementen, von denen mindestens eines eine Abschlußoberfläche aufweist und als Abschlußelement dient, aus dem Lotbad ausgetaucht wird.

14. Verfahren nach Anspruch 13,
dadurch gekennzeichnet,
daß die Leiterplatte zwischen den beiden umlaufenden Elementen durch aufeinanderfolgende Zonen unterschiedlicher Temperatur geführt wird, wobei diese Zonen eine Leiterplattenförderstrecke definieren, wodurch eine Abschreckung der Lotlegierung in den Hohlräumen erfolgt, die über den zu belotenden Bereichen liegen.

15. Verfahren nach Anspruch 14,
gekennzeichnet durch
Heizung der im Lotbad eintauchenden untersten Zone und Kühlung mindestens einer Zone, die vorzugsweise am Ende der Leiterplattenförderstrecke angeordnet ist.

16. Verfahren nach einem der Ansprüche 13 - 15,
gekennzeichnet durch
folgende Schritte:
Aufsetzen der Leiterplatte mit einer Seitenkante in etwa senkrechter Stellung auf einen Greifarm;
Eintauchen des mit der Leiterplatte versehenen Greifarms in das Lotbad;
Zuführen der Leiterplatte zu einem Einführungsbereich, der durch die als im wesentlichen gegenseitig anliegende Förderbänder ausgebildeten umlaufenden Elemente gebildet wird;
Aufnehmen der Leiterplatte durch die Förderbänder und dabei Abheben aus dem Greifarm;
Transport der Leiterplatte zwischen den beiden Förderbändern unter definiertem Anpreßdruck;
Entlangführen durch die Zonen unterschiedlicher Temperatur bis hin in die Kühlzone;
und
Auswerfen der fertig beloteten Platine bzw. Leiterplatte in einem Platinenausgabebereich.

17. Verfahren nach Anspruch 16,
gekennzeichnet durch
Zuführen der Platine innerhalb des Lotbades zum Einführungsbereich entlang einer im wesentlichen parallel zur Leiterplattenoberfläche verlaufenden Bewegungsbahn.

18. Vorrichtung zum Tauchbeloten von Leiterplatten (1, 31) mit einer den Lotauftrag seitlich definierenden Begrenzungsschicht, mit
- einer Haltevorrichtung (30), an der eine zur Tauchbelotung vorbereitete Leiterplatte (31) anbringbar ist,
- einer Transportvorrichtung (35), mit der die Haltevorrichtung (30) mit einer vertikalen und/oder horizontalen Komponente bewegbar ist, sowie
- einem Lotbehälter (36) mit flüssigem Lot, in welchen die mit einer Leiterplatte (31) bestückte Haltevorrichtung (36) einführbar ist,
dadurch gekennzeichnet, daß
- mindestens eine Abdeckvorrichtung (37) vorgesehen ist,
- die im Lotbehälter (36) gegen die benetzte Oberfläche der Leiterplatte (31) preßbar und in Preßstellung zusammen mit der Leiterplatte (31) aus dem Lotbehälter (36) austauchbar ist.

19. Vorrichtung nach Anspruch 18,
dadurch gekennzeichnet,
daß die Abdeckvorrichtung (37) an der Haltevorrichtung (30) schwenkbefestigt ist.

20. Vorrichtung nach Anspruch 18 oder 19,
dadurch gekennzeichnet,
daß die Abdeckvorrichtung (37) Antriebsmittel (42) zur Durchführung der Anpreß-Schließbewegung aufweist.

21. Vorrichtung nach einem der vorhergehenden Ansprüche 18 - 20,
dadurch gekennzeichnet,
daß der Anpreßdruck der Abdeckvorrichtung (37) auf die Oberfläche der Leiterplatte (31) durch eine in Schließrichtung vorgespannte Feder (42) ausgeübt wird, die mittels einer Rastvorrichtung beim Eintauchvorgang in Öffnungsstellung gehalten wird und durch eine Raststellungs-Freigabevorrichtung in die Schließstellung überführt wird.

22. Vorrichtung nach einem der vorhergehenden Ansprüche 18 - 21,
dadurch gekennzeichnet,
daß ein motorischer Antrieb (43) vorgesehen ist, mittels dessen die Haltevorrichtung innerhalb des Lotbehälters (36) bewegbar, vorzugsweise in eine Hin-und Herbewegung versetzbar ist.

23. Vorrichtung nach Anspruch 22,
dadurch gekennzeichnet,
daß der Antrieb ein Vibrator (43) ist.

24. Vorrichtung nach einem der vorhergehenden Ansprüche 18 - 23,
gekennzeichnet durch
Lotmittelturbulenzdüsen (44) für das schmelzflüssige Lot im Bereich der Haltevorrichtung (30) und/oder fest oder beweglich installiert im Bereich des Lotbadspiegels.

25. Vorrichtung nach Anspruch 18, insbesondere zur Durchführung des Verfahrens nach einem der Ansprüche 13 - 17,
dadurch gekennzeichnet,
daß die Abdeckvorrichtung als Förderband (53 oder 54) ausgebildet ist, an dessen Oberfläche die Leiterplatte (64) unter definiertem Anpreßdruck anliegt und aus dem Lotbad (51) geführt wird.

26. Vorrichtung nach Anspruch 25,
dadurch gekennzeichnet,
daß die Abdeckvorrichtung aus zwei gegensinnig umlaufenden, zwischen sich einen Aufnahmespalt ggf. variabler Weite bildenden Förderbändern (53, 54) besteht.

27. Vorrichtung nach Anspruch 26,
dadurch gekennzeichnet,
daß die Förderbänder (53, 54) je auf einem die Bandunterseiten abstützenden Förderbandgehäuse (59, 60) laufen.

28. Vorrichtung nach Anspruch 27,
dadurch gekennzeichnet,
daß in dem Förderbandgehäuse (59 bzw. 60) unterschiedlich temperierte Zonen (59a - 59d bzw. 60a - 60d) ausgebildet sind.

29. Vorrichtung nach einem der vorhergehenden Ansprüche 26 - 28,
gekennzeichnet durch
eine Haltevorrichtung (61) , die eine Aufnahmeeinrichtung (63) zur i. w. senkrechten Halterung einer Leiterplatte (64) von unten aufweist und mit welcher die Leiterplatte von unten in einen Einführungsbereich (65) zwischen den beiden Förderbändern (53, 54) einführbar ist.

30. Vorrichtung nach einem der vorhergehenden Ansprüche 18 - 24, die in einer mehrere Bearbeitungsstationen aufweisenden, zumindest teilweise automatisierten Bearbeitungsstraße angeordnet ist,
dadurch gekennzeichnet,
daß vor der den Lotbehälter enthaltenden Station eine Begrenzungsschicht-Auftragsstation, eine Begrenzungsschicht-Festlegungsstation zur exakten bereichsmäßigen Abgrenzung der Begrenzungsschicht und nach der den Lotbehälter enthaltenden Station eine Begrenzungsschicht-Entfernungsstation zur selektiven Ablösung der Begrenzungsschicht angeordnet ist.

31. Tauchbelotete Leiterplatte,
dadurch gekennzeichnet,
daß die Leiterplatte (1) auf den Bereichen (3), die nach dem SMD-Verfahren mit Bauteilen bestückt werden, SMD-Bereiche genannt, einen an der Oberfläche im wesentlichen ebene Lotauftrag (20) von etwa rechteckigem Querschnitt, rechtwinklig zur Leiterplattenebene genommen, aufweist, und daß Seitenflächen des Lotauftrags (20) durch eine Lotauftrag-Begrenzungsschicht (10) geformt sind.

32. Leiterplatte nach Anspruch 31,
dadurch gekennzeichnet,
daß die etwa parallel zur Leiterplatte verlaufende Oberfläche des Lotauftrags (20) durch eine Dichtungsschicht (18) des Abschlußelements (15) geformt ist.

## Claims

1. Method for dip-soldering printed circuit boards, characterised by the following process steps:
a) production of a printed circuit board with electrically conductive areas, eg. soldering pads or SMD soldering surfaces, to which solder is to be applied;
b) defining these areas with a delimiting solder-repellant layer of a given thickness which essentially corresponds to the thickness of the solder to be applied;
c) dipping the printed circuit board that has been prepared in this manner into a soldering bath with a suitable soldering alloy;
d) covering the cavities which are located over the areas to be soldered and are filled with fluid solder in the soldering bath, with at least one closing element at a given contact pressure;
e) removing the covered printed circuit board from the soldering bath;
f) reducing the temperature to below the hardening temperature of the soldering alloy;
g) removing the closing element;
h) optionally removing the delimiting layer.

2. Method according to Claim 1, characterised in that the delimiting layer is formed by a photo-sensitive solder-repellant mask or by a foil layer which can be applied to specific areas.

3. Method according to Claim 1 or 2, characterised in that the delimiting layer has a thickness of approximately 10 µm - 700 µm, preferably 50 µm - 300 µm.

4. Method according to any one of the preceding claims, characterised in that the delimiting layer can either be detached mechanically from the surface of the printed circuit board or be chemically dissolved.

5. Method according to any one of the preceding claims, characterised in that the areas to be soldered are the SMD soldering surfaces of the plate and the irradiated areas of a photo-sensitive solder-repellant mask used as a delimiting layer are removed after irradiation of the delimiting layer with an irradiation stencil defining the SMD soldering surfaces.

6. Method according to any one of the preceding claims, characterised in that a flow medium is applied to the SMD soldering surfaces before the printed circuit board is dipped.

7. Method according to any one of the preceding claims, characterised by a primary soldering by the molten metal method on all areas of the printed circuit board that are to be soldered, such as, for example, soldering lands, through connections, SMD soldering surfaces or soldering pads.

8. Method according to any one of the preceding claims, characterised in that only the SMD soldering surfaces or soldering pads are not covered by the delimiting layer.

9. Method according to any one of the preceding claims, characterised in that the soldering material flows towards the printed circuit board surface under additionally generated turbulence, in particular when the printed circuit board is dipped into the molten soldering bath.

10. Method according to any one of the preceding claims, characterised in that the closing element covers, under resilient pressure, the cavities above the areas.

11. Method according to any one of the preceding claims, characterised in that the closing element has a closing surface which seals and/or which the solder cannot moisten.

12. Method according to any one of the preceding claims, characterised in that the closing surface of the closing element is deformable and, when pressed onto the surface of the printed circuit board, is pressed, at least in given areas, into the cavities above the areas to be soldered.

13. Method according to any one of the preceding claims, characterised in that the printed circuit board is removed from the solder bath between two moving rotating elements, of which at least one has a closing surface and acts as the closing element.

14. Method according to Claim 13, characterised in that the printed circuit board is guided between the two rotating elements through successive zones of different temperatures, these zones defining a printed circuit board supply path, whereby the soldering alloy is chilled in the cavities above the areas to be soldered.

15. Method according to Claim 14, characterised by heating of the lowest zone dipped in the soldering bath, and cooling of at least one zone, which is preferably disposed at the end of the printed circuit board supply path.

16. Method according to any one of Claims 13 to 15, characterised by the following steps: setting the printed circuit board such that one lateral edge is in an approximately perpendicular setting on a gripping arm;
dipping the gripping arm, provided with the printed circuit board, into the soldering bath; guiding the printed circuit board to an inlet area, which is formed by the rotating elements formed as essentially mutually abutting conveyor belts;
taking-up the printed circuit board by the conveyor belts, and thus lifting it out of the gripping arm;
transporting the printed circuit board between the two conveyor belts at a given contact pressure;
guiding through the zones of differing temperature to the cooling zone; and
ejecting the completely soldered plate or printed circuit board in a plate discharge area.

17. Method according to Claim 16, characterised by the delivery of the plate, within the soldering bath, to the inlet area along a path of travel that extends substantially parallel to the surface of the printed circuit board.

18. Device for dip-soldering printed circuit board (1, 31) with a delimiting layer laterally delimiting the solder application, having
- a retaining device (30), on which a printed circuit board (31) prepared for dip-soldering can be mounted;
- a transport device (35), by means of which the retaining device (30) can be moved using a vertical and/or horizontal component; and
- a solder container (36) with fluid solder, into which the retaining device (36) on which a printed circuit board (31) is mounted, can be introduced;
characterised in that
- at least one covering element (37) is provided;
- which can, in the solder container (36), be pressed against the moistened surface of the printed circuit board (31) and, in the pressed position, can be removed from the solder container (36) together with the printed circuit board (31).

19. Device according to Claim 18, characterised in that the covering device (37) is mounted so as to pivot on the retaining device (30).

20. Device according to Claim 18 or 19, characterised in that the covering device (37) has drive means (42) for performing the pressing-closing movement.

21. Device according to any one of the preceding Claims 18 to 20, characterised in that the pressure of the covering device (37) on the surface of the printed circuit board (31) is exerted by a spring (42) which is pretensioned in the direction of closure and is retained in the open position during the dipping process by means of an engagement device, and is transferred into the closed position by means of an engagement position releasing device.

22. Device according to any one of the preceding Claims 18 to 21, characterised in that a motor drive (43) is provided, by means of which the retaining device can be moved, preferably in a reciprocating manner, inside the solder container (36).

23. Device according to Claim 22, characterised in that the drive is a vibrator (43).

24. Device according to any one of the preceding Claims 18 to 23, characterised by solder turbulence nozzles (44) for the molten solder in the vicinity of the retaining device (30) and/or installed in a fixed or movable manner in the vicinity of the solder bath level.

25. Device according to Claim 18, in particular for performing the method according to any one of Claims 13 to 17, characterised in that the covering device is formed as a conveyor belt (53 or 54), on the surface of which the printed circuit board (64) abuts at a given pressure and is guided out of the solder bath (51).

26. Device according to Claim 25, characterised in that the covering device consists of two counter rotating conveyor belts (53, 54) forming between them a take-up channel, optionally of variable width.

27. Device according to Claim 26, characterised in that the conveyor belts (53, 54) each travel on one conveyor belt casing (59, 56) supporting the undersides of the belt.

28. Device according to Claim 27, characterised in that zones (59a - 59d or 60a - 60d) of different temperatures are formed in the conveyor belt casing (59 or 60).

29. Device according to any one of the preceding Claims 26 to 28, characterised by a retaining device (61) which has a take-up device (63) for retaining a printed circuit board (64) from below in a substantially perpendicular position and by means of which the printed circuit board can be introduced from below into an inlet area (65) between the two conveyor belts (53, 54).

30. Device according to any one of the preceding Claims 18 to 24, which is disposed in a processing line, comprising a plurality of processing sections and is at least partially automated, characterised in that, in front of the station containing the solder container, there is arranged a station for defining the delimiting layer for the exact local delimitation of the delimiting layer, and after the station containing the solder container, a removal station for the delimiting layer is arranged for the selective removal of the delimiting layer.

31. Dip-soldered printed circuit board, characterised in that the printed circuit board (1) on the areas (3) which are equipped with components after the SMD process, known as SMD areas, has a substantially flat application of solder (20) on the surface, which application is of approximately right angled cross-section when viewed at right angles to the plane of the printed circuit board, and in that lateral surfaces of the solder application (20) are formed by a solder application delimiting layer (10).

32. Printed circuit board according to Claim 31, characterised in that the surface of the solder application (20) extending approximately parallel to the printed circuit board is formed by a sealing layer (18) of the closing element (15).

## Revendications

1. Procédé de réalisation de soudures au trempé sur des plaquettes à circuit imprimé, caractérisé par les opérations suivantes :
a) préparer une plaquette à circuit imprimé comportant des zones électriquement conductrices, par exemple plots de soudage ou surfaces de soudage SMD, qui doivent être pourvues d'un apport de soudure ;
b) délimitation de ces zones à l'aide d'une couche de délimitation empêchant le soudage et ayant une épaisseur déterminée qui correspond approximativement à la hauteur de l'apport de soudure à produire ;
c) immerger la plaquette à circuit imprimé ainsi préparée dans un bain de soudure comportant un alliage de soudure approprié ;
d) recouvrir d'au moins un élément de fermeture, sous une pression de serrage déterminée, les cavités qui sont situées au-dessus des zones à pourvoir de soudures et qui sont remplies de soudure en fusion dans le bain de soudure ;
e) extraire du bain de soudure la plaquette à circuit imprimé recouverte ;
f) amener la température au-dessous de la température de solidification de l'alliage de soudure ;
g) ôter l'élément de recouvrement ;
h) ôter éventuellement la couche de délimitation.

2. Procédé suivant la revendication 1, caractérisé en ce que la couche de délimitation est formée à l'aide d'un masque photosensible d'arrêt de soudure ou à l'aide d'une feuille pouvant être appliquée par zones.

3. Procédé suivant la revendication 1 ou 2, caractérisé en ce que la couche de délimitation a une épaisseur comprise entre environ 10 µm et 700 µm, de préférence entre 50 µm et 300 µm.

4. Procédé suivant l'une des revendications précédentes, caractérisé en ce que la couche de délimitation peut soit être séparée de la surface de la plaquette à circuit imprimé par des moyens mécaniques, soit être dissoute par voie chimique.

5. Procédé suivant l'une des revendications précédentes, caractérisé en ce que les zones devant être pourvues de soudures sont les surfaces de la platine destinées au soudage SMD et en ce qu'après exposition à la lumière d'un masque photosensible d'arrêt de soudure, servant de couche de délimitation et pourvu d'un modèle de photogravure déterminant les surfaces de soudage SMD, on ôte les zones exposées de la couche de délimitation.

6. Procédé suivant l'une des revendications précédentes, caractérisé en ce qu'avant d'immerger la plaquette à circuit imprimé, on procède au dépôt d'un décapant sur les surfaces de soudage SMD.

7. Procédé suivant l'une des revendications précédentes, caractérisé par un dépôt primaire de soudure, par voie métallurgique à l'état fondu, sur toutes les zones de la plaquette à circuit imprimé devant être pourvues de soudures, telles que par exemple pastilles de soudage, contacts traversants, surfaces de soudage SMD ou "plots de soudage".

8. Procédé suivant l'une des revendications précédentes, caractérisé en ce qu'exclusivement les surfaces de soudage SMD ou plots de soudage ne sont pas recouverts par la couche de délimitation.

9. Procédé suivant l'une des revendications précédentes, caractérisé en ce qu'on produit un afflux de la matière de soudage sur la surface de la plaquette à circuit imprimé, notamment par immersion dans le bain de soudure à l'état fondu dans lequel est en outre produite une turbulence.

10. Procédé suivant l'une des revendications précédentes, caractérisé en ce que l'élément de fermeture recouvre avec une pression élastique les cavités situées au-dessus desdites zones.

11. Procédé suivant l'une des revendications précédentes, caractérisé en ce que l'élément de fermeture comporte une surface de fermeture assurant l'étanchéité et/ou ne pouvant pas être mouillée par la soudure.

12. Procédé suivant l'une des revendications précédentes, caractérisé en ce que la surface de fermeture de l'élément de fermeture est déformable et est enfoncée au moins partiellement, lorsqu'on l'applique sur la surface de la plaquette à circuit imprimé, dans les cavités situées au-dessus des zones devant être pourvues de soudures.

13. Procédé suivant l'une des revendications précédentes, caractérisé en ce que la plaquette à circuit imprimé est extraite du bain de soudure entre deux éléments mobiles qui se déplacent suivant un mouvement de révolution et dont au moins l'un comporte une surface de fermeture et sert d'élément de fermeture.

14. Procédé suivant la revendication 13, caractérisé en ce que la plaquette à circuit imprimé passe, entre les deux éléments animés d'un mouvement de révolution, par des zones successives ayant des températures différentes, ces zones définissant une voie de transport de plaquette à circuit imprimé, de sorte qu'il se produit un refroidissement brusque de l'alliage de soudure dans les cavités qui sont situées au-dessus des zones devant être pourvues de soudures.

15. Procédé suivant la revendication 14, caractérisé par un chauffage de la zone immergée dans le bain de soudure qui est la plus basse et par un refroidissement d'au moins une zone qui est de préférence disposée à l'extrémité de la voie de transport de plaquette à circuit imprimé.

16. Procédé suivant l'une des revendications 13 à 15, caractérisé par les opérations suivantes :
- poser la plaquette à circuit imprimé par un bord latéral sur un bras de préhension, en position pratiquement verticale ;
- immerger dans le bain de soudure le bras de préhension pourvu de la plaquette à circuit imprimé ;
- acheminer la plaquette à circuit imprimé à une zone d'introduction qui est constituée par les éléments animés d'un mouvement de révolution qui sont réalisés sous la forme de bandes transporteuses pratiquement en appui face à face ;
- prélever la plaquette à circuit imprimé à l'aide des bandes transporteuses et donc la soulever du bras de préhension ;
- transporter la plaquette à circuit imprimé entre les deux bandes transporteuses sous une pression déterminée de serrage ;
- la guider dans les zones à températures différentes jusque dans la zone de refroidissement ;
- et éjecter dans une zone de sortie de platine la plat ne ou plaquette à circuit imprimé définitivement pourvue de soudures.

17. Procédé suivant la revendication 16, caractérisé par l'acheminement de la platine à l'intérieur du bain de soudure jusqu'à la zone d'introduction, le long d'une voie de déplacement pratiquement parallèle à la surface de la plaquette à circuit imprimé.

18. Installation de réalisation de soudures au trempé sur des plaquettes à circuit imprimé (1, 31) comportant une couche de délimitation délimitant latéralement l'apport de soudure, comprenant :
- un dispositif de fixation (30), sur lequel peut être montée une plaquette à circuit imprimé (31) préparée pour être pourvue de soudures au trempé,
- un dispositif de transport (35), à l'aide duquel le dispositif de fixation (30) peut être animé d'un mouvement à composantes verticale et/ou horizontale, et
- une cuve de soudure (36), contenant de la soudure liquide, dans laquelle le dispositif de fixation (30) pourvu d'une plaquette à circuit imprimé (31) peut être introduit,
caractérisée en ce qu'il est prévu au moins un dispositif de recouvrement (37) qui est agencé de façon à pouvoir, dans la cuve de soudure (36), être serré contre la surface mouillée de la plaquette à circuit imprimé (31) et de façon à pouvoir être extrait du bain contenu dans la cuve de soudure (36) en étant serré contre la plaquette à circuit imprimé (31).

19. Installation suivant la revendication 18, caractérisée en ce que le dispositif de recouvrement (37) est fixé de manière basculante sur le dispositif de fixation (30).

20. Installation suivant la revendication 18 ou 19, caractérisée en ce que le dispositif de recouvrement (37) comprend des moyens d'entraînement (42) permettant l'exécution du mouvement de serrage-fermeture.

21. Installation suivant l'une des revendications précédentes 18 à 20, caractérisée en ce que la pression de serrage du dispositif de recouvrement (37) sur la surface de la plaquette à circuit imprimé (31) est exercée par un ressort (42) qui est soumis à une précontrainte en direction de la fermeture et qui est maintenu en position ouverte à l'aide d'un mécanisme de verrouillage lors de l'opération d'immersion et passe en position de fermeture sous l'action d'un dispositif le libérant de la position de verrouillage.

22. Installation suivant l'une des revendications précédentes 18 à 21, caractérisée en ce qu'il est prévu un entraînement (43) par moteur à l'aide duquel le dispositif de fixation peut être déplacé à l'intérieur de la cuve de soudure (36), de préférence suivant un mouvement d'aller et retour.

23. Installation suivant la revendication 22, caractérisée en ce que le dispositif d'entraînement est un vibrateur (43).

24. Installation suivant l'une des revendications précédentes 18 à 23, caractérisée par des buses à turbulence (44) fournissant la soudure à l'état liquide dans la zone du dispositif de fixation (30) et/ou montées d'une manière fixe ou mobile dans la zone de la surface libre du bain de soudure.

25. Installation suivant la revendication 18, notamment pour la mise en oeuvre du procédé suivant l'une des revendications 13 à 17, caractérisée en ce que le dispositif de recouvrement est réalisé sous la forme d'une bande transporteuse (53 ou 54) sur la surface de laquelle la plaquette à circuit imprimé (64) est appliquée sous une pression déterminée de serrage et est extraite du bain de soudure (51).

26. Installation suivant la revendication 25, caractérisée en ce que le dispositif de recouvrement est constitué de deux bandes transporteuses (53, 54) animées de mouvements de révolution en sens opposés et formant entre elles un intervalle de prélèvement, éventuellement à largeur variable.

27. Installation suivant la revendication 26, caractérisée en ce que chacune des bandes transporteuses (53, 54) se déplace sur un boîtier de bande transporteuse (59, 60) soutenant la bande par sa face inférieure.

28. Installation suivant la revendication 27, caractérisée en ce que des zones (59a-59d ou 60a-60d) maintenues à des températures différentes sont ménagées dans le boîtier de bande transporteuse (59 ou 60).

29. Installation suivant l'une des revendications précédentes 26 à 28, caractérisée par un dispositif de fixation (61) qui comprend un moyen de prélèvement (63) servant à maintenir par dessous une plaquette à circuit imprimé (64), d'une manière pratiquement verticale, et à l'aide duquel la plaquette à circuit imprimé peut être introduite par en dessous dans une zone d'introduction (65) située entre les deux bandes transporteuses (53, 54).

30. Installation suivant l'une des revendications précédentes 18 à 24, qui est disposée dans une ligne de traitement au moins partiellement automatisée comportant plusieurs postes de traitement, caractérisée en ce qu'en amont du poste contenant la cuve de soudage, il est disposé un poste d'application de la couche de délimitation et un poste de fixation de cette dernière qui servent à délimiter cette couche de délimitation par zones et d'une manière exacte et en ce qu'en aval du poste contenant la cuve de soudage, il est disposé un poste de suppression de la couche de délimitation qui sert à séparer cette dernière d'une manière sélective.

31. Plaquette à circuit imprimé pourvue de soudures au trempé, caractérisée en ce que, sur ses zones (3) qui sont pourvues de composants conformément au procédé SMD, appelées zones SMD, la plaquette à circuit imprimé (1) comporte un apport de soudure (20) pratiquement plan en surface et à section transversale approximativement rectangulaire perpendiculairement au plan de la plaquette à circuit imprimé et en ce que des surfaces latérales de l'apport de soudure (20) sont formées par une couche (10) de délimitation de l'apport de soudure.

32. Plaquette à circuit imprimé suivant la revendication 31, caractérisée en ce que la surface de l'apport de soudure (20) qui est pratiquement parallèle à la plaquette à circuit imprimé est formée par une couche d'étanchéité (18) de l'élément de fermeture (15).
